(19) Europäisches Patentamt European Patent Office Office européen des brevets

(11) **EP 1 830 464 A1**

(12) **EUROPEAN PATENT APPLICATION**

(43) Date of publication:
**05.09.2007 Bulletin 2007/36**

(51) Int Cl.:
*H03F 3/217* (2006.01)     *H03F 1/32* (2006.01)

(21) Application number: **06388014.0**

(22) Date of filing: **01.03.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Danmarks Tekniske Universitet 2800 Kgs. Lyngby (DK)**

(72) Inventors:
• **Andersen, Michael A.E.**
  **2830 Virum (DK)**
• **Jakobsen, Lars Tonnes**
  **2830 Kongens Lyngby (DK)**

(74) Representative: **Jensen, Peter Kim et al**
  **c/o Chas. Hude**
  **H.C. Andersens Boulevard 33**
  **1780 Copenhagen V (DK)**

(54) **Digital self-oscillating modulator**

(57)     A digital self-oscillating modulator (1) comprises a forward loop and a feedback loop. The feedback loop comprises a feedback block (18) having a transfer function (MFB) and a digital output. The forward loop comprises an alternating output stage (14), an optional output filter (15), and a forward block (12) having a transfer function (MFW) and a digital output. The digital output from the forward block (12) is input to the alternating stage (14). The forward block is provided with means for calculating the difference between the digital output from the feedback block and a digital reference signal. The output voltage of the modulator either from the alternating output stage (14) and/or the output filter (15) is fed back through the feedback block.

Fig. 1

Printed by Jouve, 75001 PARIS (FR)

**Description**

The present invention relates to a digital self-oscillating modulator comprising a forward loop and a feedback loop.

The switching-mode power conversion technology has over the years radically changed the appearance of commercial products, making them far smaller than a few decades ago and leaving the designers with possibilities to experiment with their look and feel without being limited by technology barriers. These benefits are a direct result of the improved efficiency of the power supplies and power amplifiers that use a switching approach instead of a linear one. As a side effect, the amount of heatsinking material needed is reduced by at least an order of magnitude, which improves the level of integration between the various components, so that the overall board space, weight and volume are significantly reduced and power density is improved. The aforementioned advantages are probably most clearly seen in the switching-mode Class D audio power amplifiers, where the new efficient power conversion principle has opened the doors to some new and challenging application areas, from small low-end portable devices with extended battery life to large high-end audio installations for stage performances with tremendously reduced dimensions.

The achievements in the field of switching-mode audio power amplification in the last few years, described in terms of even higher output power levels and improved audio performance, are drawing this approach on the technology map as one of the most significant breakthroughs that is eventually going to replace linear electronics in most power processing applications. However, this does not mean that the present Class D audio power amplifiers are the only possible solution that fits all applications, and much research is done to take the most advantage from the very high conversion efficiency of the switching-mode approach while still keeping the complexity and component count to a minimum.

These unique challenges, posed predominantly by the audio and video product manufacturers wanting to penetrate the low-end market by cutting production costs and introducing cheap products of satisfactory quality, can be answered by further and closer integration of the constitutive parts of the audio power amplifier, i.e. the switching-mode power supply and the Class D amplifier, which until now usually have been viewed as separate parts without many touching points.

Several initiatives to improve power conversion systems using a control approach that utilises the self-oscillating principle have been proposed.

DE 198 38 765 discloses a power amplifier employing a hysteresis control for generating pulse width modulated voltages. The difference between the input voltage and the output voltage is integrated in this power amplifier, said difference being stepped down by a factor corresponding to the ratio of the maximum level of the input voltage to the maximum level of the output voltage.

The difference between the scaled output signal and the input signal corresponds to the instantaneous amplitude error of the output signal with the result that the integration corresponds to the accumulated error on the output. The output signal of the integrator is triangular, and when the power amplifier is running idle, the slope of said triangle is of the same value for both the positive and the negative flanks. When the power amplifier is to be set, i.e. loaded, these flanks change in such a manner that the positive flank discloses a slope differing from the slope of the negative flank. However, the curve shape remains triangular with straight flanks. As the power amplifier is increasingly loaded, the switch-frequency decreases as well. As a result, for instance the input signal to the power amplifier is sinusoidal, and then the switch-frequency is at maximum at the zero-pass for the sine curve and significantly lower at the maximum and the minimum value, respectively, of said sine curve. When the power amplifier is loaded to its maximum, i.e. when the maximum value of the output voltage is almost identical with the internal DC-voltage of the power amplifier, the switch-frequency becomes very low, almost zero. The triangular signal from the integrator is transferred to a comparator, typically a Schmitt-trigger, which converts the triangular signal into square pulses of a varying pulse width. These square pulses are the switching on signals and the switching off signals, respectively, for the transistors in the power amplifier. These switching on pulses are transferred to the output stage of the power amplifier, viz. to the transistors in the output, and therefore these pulses are upscaled by the relation between said pulse voltages and the internal DC-voltage of the power amplifier. The resulting voltage includes square pulses and is typically of a higher amplitude than the signal voltage. The square voltage is then transmitted to the output filter of the power amplifier, said output filter typically being a second order filter, which is often referred to as a reconstruction filter. The voltage applying after the filter is the output voltage of the power amplifier. The voltage returned to the integrator is the voltage applying before the output filter. A modulator of this type is often referred to as an Astable Integrating Modulator or an AIM. Such a modulator is encumbered with the problem that the distortions of the output filter have not been taken into account. In addition, the operational amplifier used to construct the integrator has to be of high quality.

WO 02/25357 discloses a controlled oscillation modulator, also called a COM. The COM ensures that the open-loop-phase characteristics involve a phase shift of exactly 180° at the frequency where the open-loop-amplification is 0 dB. The latter is rendered possible by the feedback voltage from the output stage of the power amplifier being forwarded through function blocks causing a phase shift of 180° and/or through function blocks with time delays. The desired phase shift of 180° is obtained by including said phase shift in the function blocks, such as in form of a cascade coupling of poles, and/or by choosing a suitable time delay. When the feedback loop is subsequently closed, the modulator oscillates at the frequency, where the amplification is 0 dB. When the input signal to the power amplifier is 0, the resulting signal is a substantially pure sine. When the input signal differs from 0, the oscillation is superimposed by the input signal. A comparator is subsequently used for generating the switching pulses of the output stage. An increasing loading of the amplifier has the effect that the pure sine resulting from the phase shift of 180° is altered into being something between the pure sine and the triangular voltage known from AIM. The linearity of a modulator depends on variations in the inclination of this signal. As this signal is not a pure triangular curve unlike AIM, but instead something between a sine curve and a triangular curve, the modulator according to the COM principle is nonlinear, and the modulation per se distorts the output signal.

WO 98/19391 describes a way of improving a class D power amplifier. The amplifier includes an internal modulator generating the well-known pulse-width modulated output signal. This signal is transmitted to an output filter, and the resulting filtered signal is the output voltage of the power amplifier. In order to compensate for the distortions of the filter, additional feedback loops have been included, and the characteristics of these feedback loops can compensate for the distortions of said output filter. The described system includes several cascade-coupled feedback loops for compensating the distortions. The system shows an improved procedure structure with respect to power amplifiers without such feedbacks, but the system is per se very complex and requires much design work in order to achieve the desired effect. A system of this type is often referred to as being Multivariable Enhanced Cascade Controlled or MECC.

WO 04/100356 discloses a switch-mode modulator operating at a two-level voltage and including an alternating output stage, an optional output filter and a feedback including a function block with a transfer function. The modulator furthermore includes a forward block provided with means for calculating the difference between the signal originating from the function block and a reference signal as well as with a transfer function. The output of the forward block is the input of a Schmitt-trigger, which generates switch on signals for changing the output stage. The output voltage of the modulator applying either after the optional output filter or the output stage is fed back through the function block so as to generate the signal fed back. The transfer function of the function block and of the forward block is chosen both in response to the transfer function of the output filter and in response to the desired total open-loop-transfer function of the modulator.

US provisional application no. 60/714,077 discloses a self-oscillating modulator operating with a two-level output. The modulator comprises an alternating output stage, an optional output filter, a feedback including a function block with a transfer function, a forward block having a transfer function and is provided with means for calculating the difference between the signal originating from said function block and a reference signal. The output voltage of the modulator either from the alternating output stage and/or the output filter is fed back through the function block, and a multiplication element is placed together with the forward block before the alternating output stage. The multiplication element can thus be utilised to change the polarity of the signal sent to the alternating output stage, thereby compensating for the polarity of the power converter, in which the modulator is used.

Self-oscillating modulators represent an interesting alternative to the conventional fixed frequency pulse width modulators (PWM) for all kinds of power converters as found in almost all electronics equipment from audio power amplifiers, converters for renewable energy sources, uninterruptible power supplies to general isolated power converters and power supplies.

The object of the invention is to provide a new and improved digital self-oscillating modulator for all kinds of power converters as found in almost all electronics equipment from audio power amplifiers, converters for renewable energy sources, uninterruptible power supplies to general isolated power converters and power supplies.

This is according to the invention obtained by the feedback loop comprising a feedback block having a transfer function and a digital output, and the forward loop comprising an alternating output stage, an optional output filter, and a forward block having a transfer function and a digital output, said digital output from the forward block being input to the alternating stage, said forward block being provided with means for calculating the difference between the digital output from the feedback block and a digital reference signal, wherein an output voltage of the modulator either from the alternating output stage and/or the output filter is fed back through the feedback block.

By the term self-oscillating is meant a modulator, in which the phase shift of the open-loop transfer function is 360 degrees at the oscillation frequency of the modulator. In analogue self-oscillating modulators, the bandwidth of the modulator is limited by the switching frequency of the output stage, and in digital modulator with fixed frequency pulse width modulation, the bandwidth is limited by the sampling frequency, which is smaller than or equal to the switching frequency. In the proposed digital self-oscillating modulator, the sampling frequency is not limited by a fixed switching frequency. Thereby, the bandwidth is comparable to that of an analogue self-oscillating modulator, but the bandwidth is increased compared to conventional digital modulators. Thus, the digital self-oscillating modulator as such overcomes the Nyquist criteria imposed by the switching frequency. Additionally, an increased loop gain can be achieved. In general, the digital implementation of the self-oscillating modulator makes it possible to achieve a better performance by providing a simple modulator structure with internally created carrier, high bandwidth equal to the switching frequency, high power supply rejection ratio through intrinsic power supply voltage feedback within the modulator, the possibility for open load stability by including the output filter within the modulator feedback, as well as reduced electromagnetic interference through spread spectrum techniques in variable switching frequency mode.

According to a particular embodiment of the modulator, the transfer function of the forward block and/or the transfer function of the feedback block are frequency compensating, i.e. the transfer function has one or more poles or zero points.

According to an embodiment of the modulator, the forward block includes a comparator block. Preferably the forward block includes a comparator with hysteresis, or alternatively a comparator block and a hysteresis block. Hereby modulators with a higher basic linearity and thus lower distortion are obtained.

According to a particular embodiment of the modulator, the comparator block includes a multiplexer and a digital comparator, said multiplexer being adapted to multiplex signals from the positive and negative sides of the hysteresis block, the output from the multiplexer being sent to the digital comparator, which compares the output from the multiplexer with a digital reference signal. This reference signal can for instance be the output from a filter of the forward block. Hereby it is achieved that the output of the comparator will change according to variations in the reference signal.

In another embodiment of the modulator, the comparator block includes a digital comparator and a S-R latch. Thereby a particular simple implementation of the comparator block is introduced.

According to a particular embodiment of the modulator, the feedback loop additionally comprises an A/D-converter. If the signal fed back is analogue, which will for instance often be the case, if the output from the output filter is fed back, this signal must be converted to a digital signal, which is processed by the feedback block.

In another embodiment of the modulator according to the invention, the forward block includes an integrator. Hereby a very easy and simple implementation as well as a very high DC- and low-frequency loop gain is obtained.

According to a preferred embodiment of the modulator, the integrator comprises an adder and a clocked latch. This provides a particularly simple digital implementation of the integrator.

According to another preferred embodiment of the digital modulator according to the invention, the transfer function of the forward block, the transfer function of the feedback block, as well as the transfer function of the optional output filter depend on the desired open-loop transfer function. Thereby, for instance the transfer function of the forward block can be chosen to compensate the error signal (difference between the signal fed back and the reference signal) in an optimised way dependent of the specific modulator, and the transfer function of the output filter can be optimised to reconstruct the signal. The transfer function of the feedback block can in turn be determined from the desired open-loop transfer function.

In a preferred embodiment, the alternating output stage is a switching amplifier with bidirectional switches.

According to a particular embodiment, the means for comparing the signal fed back with the reference signal comprises of two identical digital comparator sections, which have inverted inputs.

In another embodiment according to the invention, a digital multiplication element is placed together with the forward block before the alternating output stage. The multiplication element can thus be utilised to change the digital polarity of the signal sent to the alternating output stage, thereby compensating for the polarity of for instance the power converter, in which the modulator is used.

In a preferred embodiment according to the invention, the alternating output stage is supplied with an AC-voltage from an AC-link converter and the digital multiplication element works by switching between the two identical digital comparator sections with inverted inputs, said switching being controlled by the sign of the AC-voltage from the AC-link converter. Thereby a particular simple implementation of a polarity compensating modulator is achieved.

In a preferred embodiment according to the invention, one or more of the zero points or poles of the feedback block and of the forward block are coinciding or approximately coinciding with the pole or zero points of the optional output filter.

In yet another embodiment according to the invention, the modulator further includes one or more additional output filters, one or more additional feedbacks with transfer functions coupled either after the output stage, after the output filter or after one or more of the additional output filters, as well as one or more forward blocks, which include both means for calculating the difference between one of the signals fed back from the additional function blocks and a reference signal, as well as a transfer function. Thereby even further loops to stabilise the modulator and compensate for error signals have been provided.

Preferably, the transfer function of the function block, the transfer function of the forward block, the additional output filters, the transfer functions of the additional feedback blocks and the transfer function of the additional forward blocks together are generating the desired total transfer function.

In a particularly preferred embodiment of the self-oscillating modulator, the desired total transfer function is similar to a first order low-pass-characteristic or integrator characteristic.

The purpose of the invention is also achieved by a synchronised modulator comprising two of the aforementioned digital modulators, wherein a reference voltage is input to a first digital modulator and a digital inverted reference voltage is input to a second digital modulator, the outputs from said first and said second digital modulator being synchronised by use of a synchronisation block.

The invention is now to be described in greater detail with reference to the drawings, in which

Fig. 1 shows a block diagram of a digital self-oscillating modulator (DISOM) according to the invention,

Fig. 2 a block diagram of a DISOM according to the invention with an additional outer control loop,

Figs. 3-7 different embodiments of DISOMs comprising comparators with hysteresis,

Figs. 8-14 different embodiments of GLIM type 1 DISOM modulators,

Figs. 15-21 different embodiments of GLIM type 2 DISOM modulators,

Figs. 22-24 different embodiments of hysteresis modulators with substantially constant switching frequency,

Figs. 25-31 different embodiments of phase shift types of DISOM modulators,

Figs. 32-42 different embodiments of hysteresis comparators for use in DISOMs,

Fig. 43 a block diagram of a prototype for proofing the DISOM concept,

Fig. 44 a plot of the switching frequency as a function of the duty cycle of a prototype for proofing the DISOM concept,

Fig. 45 a DC/DC converter implementing a DISOM,

Fig. 46 and 47 plots of experimental results measured on the prototype,

Fig. 48 a synchronised modulator comprising two DISOMs, and

Fig. 49 a digital implementation of a SICAM type DISOM modulator.

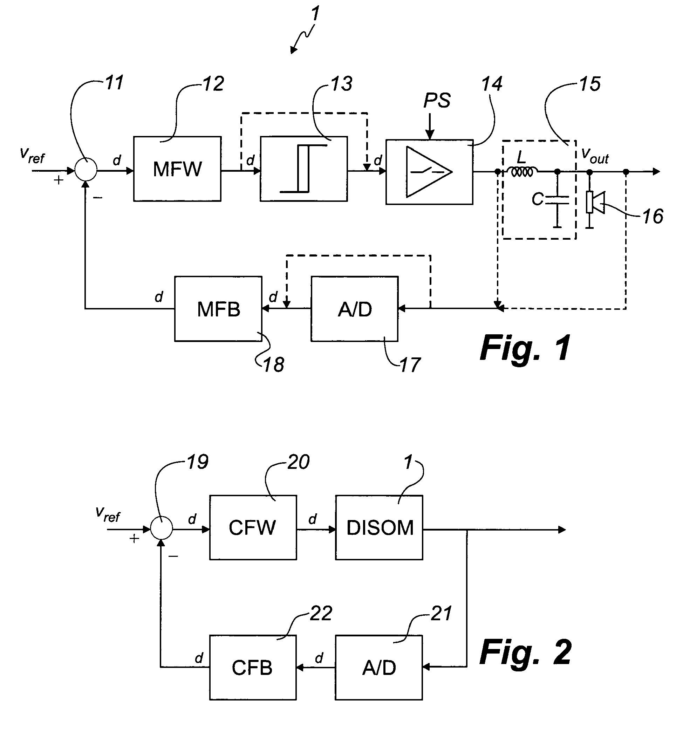

A block diagram of a digital self-oscillating modulator (DISOM) according to the invention is shown in Fig. 1. The structure is very general and can as such include digital versions of any of the conventional analogue self-oscillating modulators found in the power converters or switching audio power amplifiers with DC-link or HF-link power supplies.

The digital error signal from a summing junction 11 is fed to a modulator feed forward block 12 with the transfer function MFW. The feed forward block 12 will optionally include a hysteresis block 13 or a comparator with hysteresis. The digital output from the forward block 12 is then fed to the switching amplifier 14, which is supplied with the voltage from a power supply PS. The output from the switching stage or the switching amplifier 14 can optionally be passed through an output filter 15 and to the load 16, which can be a loudspeaker or a general load for a power converter. The output from the switching stage or the switching amplifier 14 can be regarded as either analogue or digital depending on the particular implementation of the switching stage or the switching amplifier 14, which according to a preferred embodiment is a switching power stage.

The output filter 15 is here depicted as a second order low-pass filter with passive LC components, said low-pass filter 15 for instance reconstructing a sinusoidal signal or input signal $V_{ref}$ from the square voltage from the switching stage or the switching amplifier 14. However, the output filter 15 can have any desired frequency compensating transfer function. The output from either the switching stage or the switching amplifier 14 or the output filter 15 is fed back through the modulator feedback block 18 having a transfer function MFB. The input to the feedback block 18 must be digital. Therefore, the feedback loop can optionally include an A/D-converter 17, which converts an analogue signal to a digital signal. The A/D-converter 17 is thus necessary, if the signal fed back from the switching stage or the switching amplifier 14 and/or the output filter 15 is analogue.

The digital output from the feedback block 18 is fed back to a summing junction 11, which extracts the error signal as the difference between the digital signal fed back and a digital reference signal $V_{ref}$.

The transfer functions of the feed forward block 12, the feedback block 18 and the output filter 15 can have any desired frequency dependency. The filters can inter alia be high-pass filters, low-pass filters, band-pass filters, band-stop filters or unity filters based on the desired frequency compensation of the particular self-oscillating modulator and the open loop transfer function. According to a preferred embodiment the transfer function MFW of the forward block 12 and/or the transfer function MFB of the feedback block 18 have a frequency compensating effect, i.e. one or more poles or zeros.

The digital self-oscillating modulator 1 according to the invention can have one or more outer control loops, which improve the performance of the modulator 1 even further by introducing additional gain and optimising bandwidth within a control feed forward block 20 with a transfer function CFW and a control feedback block 22 with a transfer function CFB as shown in Fig. 2. In the depicted block diagram, the difference between the signal fed back through the control feedback block 22 and the reference signal $V_{ref}$ is extracted at an additional summing junction 19. Since the output from the DISOM 1 is typically an analogue signal, the additional feedback loop can optionally include an additional A/D-converter 21.

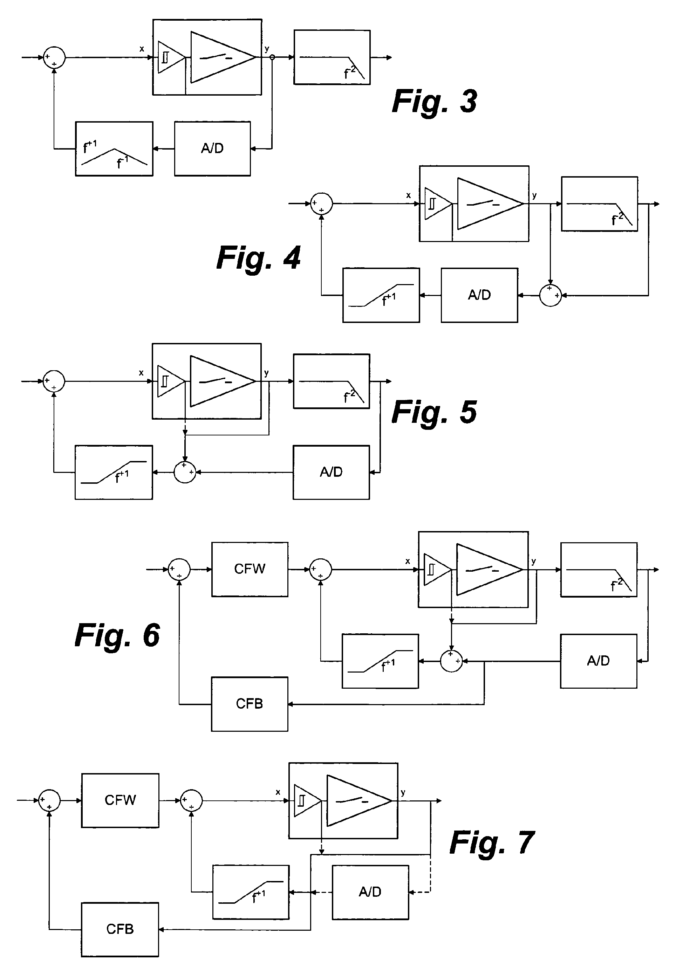

Figs. 3-7 show different embodiments of DISOMs, which include a comparator with hysteresis in the forward block 12. Fig. 3 shows a first embodiment of a DISOM version of a band-pass current control type. This embodiment will typically be combined with an outer control loop (not shown.). The illustrations of these transfer functions correspond to Bode plots, which are well known to a person skilled in the art. Fig. 4 shows a second embodiment of a DISOM version of a band-pass current control type. The current measurement is here replaced with a current estimation, for instance by directly coupling the voltage over the inductor of the LC output filter, by measuring the potential of a winding of the inductor of the output filter or via a transformer. Fig. 5 shows a third embodiment, which corresponds to the embodiment shown in Fig. 4, but where the output from the amplifier stage can be regarded as a digital signal. The fourth embodiment shown in Fig. 6 corresponds to the embodiment shown in Fig. 5 combined with an outer control loop. A fifth embodiment is shown in Fig. 7. This embodiment has a current estimation by use of the voltage at the output. The embodiment does not have an output filter and can for instance be used to drive a speaker directly, also called an active transducer (ACT) or a pulse-modulated transducer (PMT). This embodiment does not need the A/D-converter and can thus be implemented cheaply.

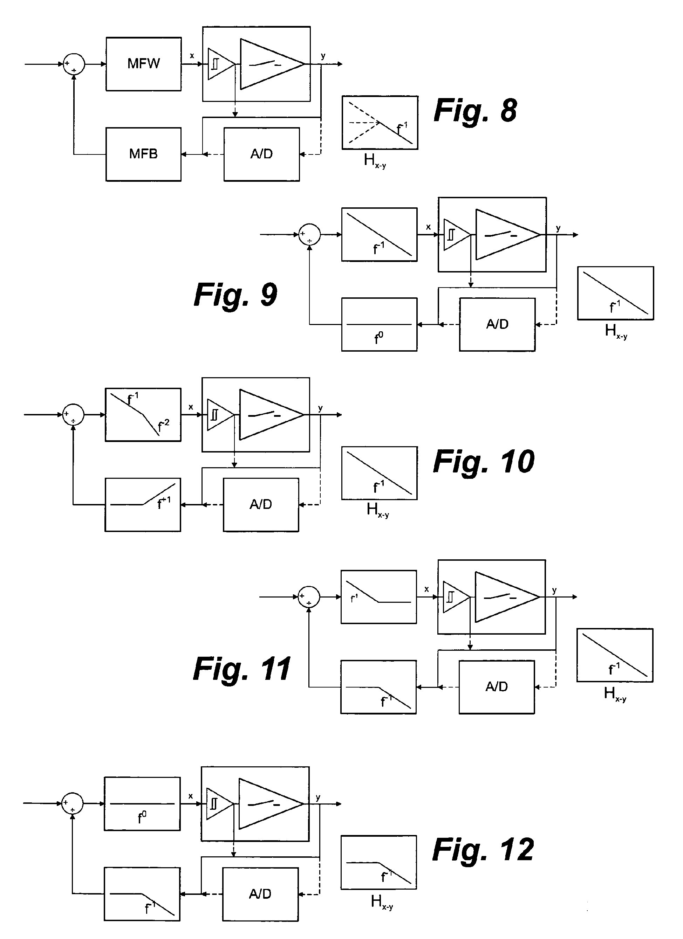

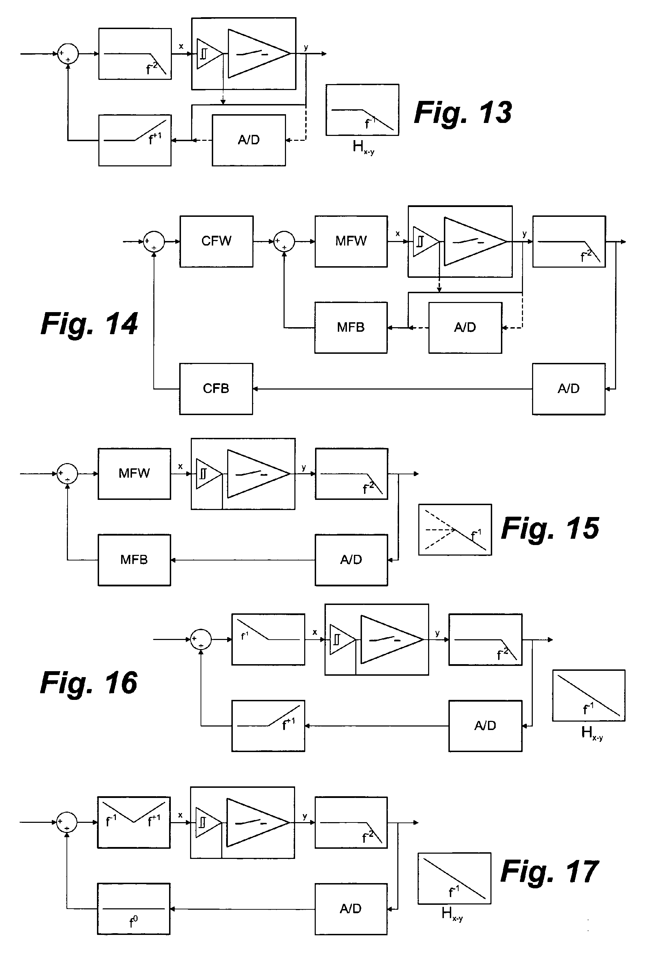

Fig. 8 shows a general block diagram of a digital version of the GLIM type 1 modulators (see also WO 04/100356), and Figs. 9-14 show different embodiments of this type of modulator. To the right in each of the figures, the y-to-x or open loop functions of the different embodiments are shown. This type of digital GLIM has a first order low-pass characteristic for the open loop transfer function. The A/D-converter can be neglected, since both the output from the hysteresis comparator, which optionally can be fed back to the feedback block, and the output from the switching stage or the switching amplifier are digital. The embodiment shown in Fig. 9 corresponds to the AIM-implementation (see also DE 198 38 765). All the GLIM type 1 embodiments are simple and cheap to implement. The embodiments can be part of a power modulator with an output filter and an outer control loop as shown in Fig. 14.

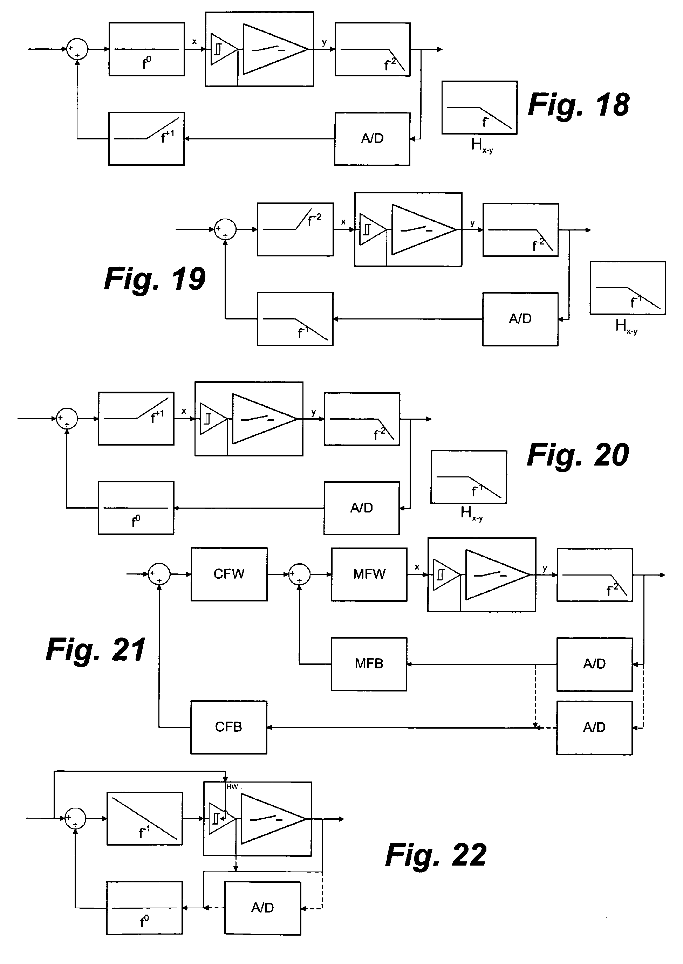

Fig. 15 shows a general block diagram of a digital version of the GLIM type 2 modulators (see also WO 04/100356), and Figs. 16-21 show different embodiments of this type of modulator. This type of digital GLIM also has a first order low-pass characteristic for the open loop transfer function. The A/D-converter must be used in this type of modulator, since the output from the output filter is analogue. Thus, the GLIM type 2 modulators are more expensive to implement, since a fast A/D-converter is necessary. As with the type 1 modulators, these embodiments can be part of a power modulator with an output filter and an outer control loop as shown in Fig. 21. In order to lower expenses, the same A/D-converter can be used for both the inner feedback loop and the outer control loop.

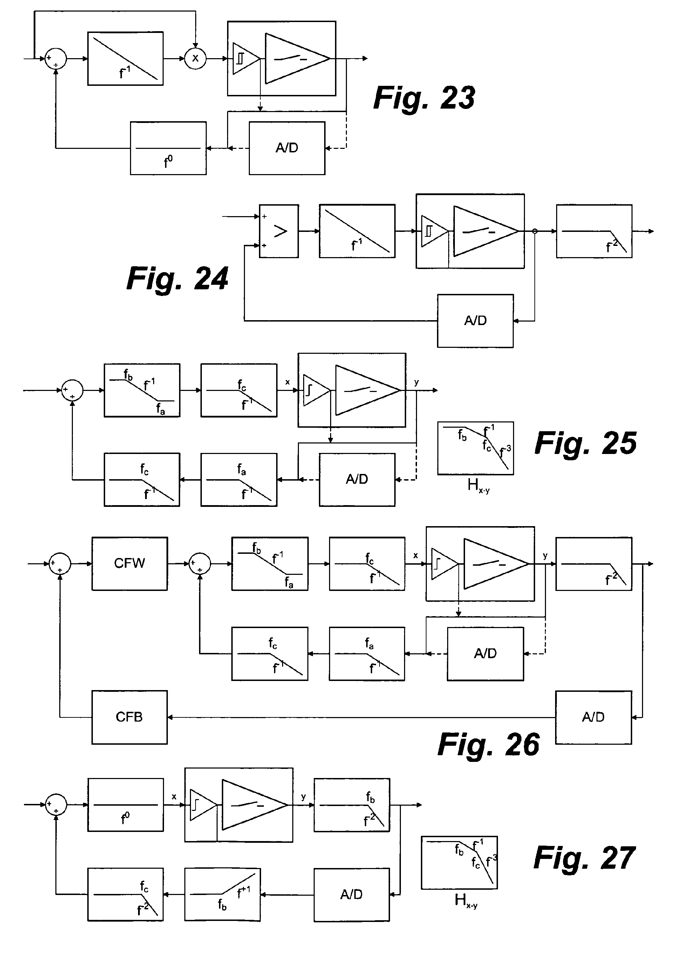

Figs. 22-24 show different embodiments of modulators with a substantially constant switching frequency, all of them being current mode types of hysteresis modulators. Fig. 22 shows a DISOM version of an AIM modulator with a variable hysteresis window, which is carried out in order to achieve a constant switching frequency. This embodiment is very simple to implement, since the input of the hysteresis window of the digital hysteresis comparator shown can be used directly without the use of an A/D-converter, since the signal is digital. Fig. 23 shows a similar embodiment, which incorporates a digital multiplicator, which makes the implementation slightly more complicated and expensive. Fig. 24 shows another embodiment, in which a digital comparator is used for comparing the signal fed back of the power converter output current and the reference signal and thus forms the summing junction 11. This embodiment must include an A/D-converter in the feedback loop.

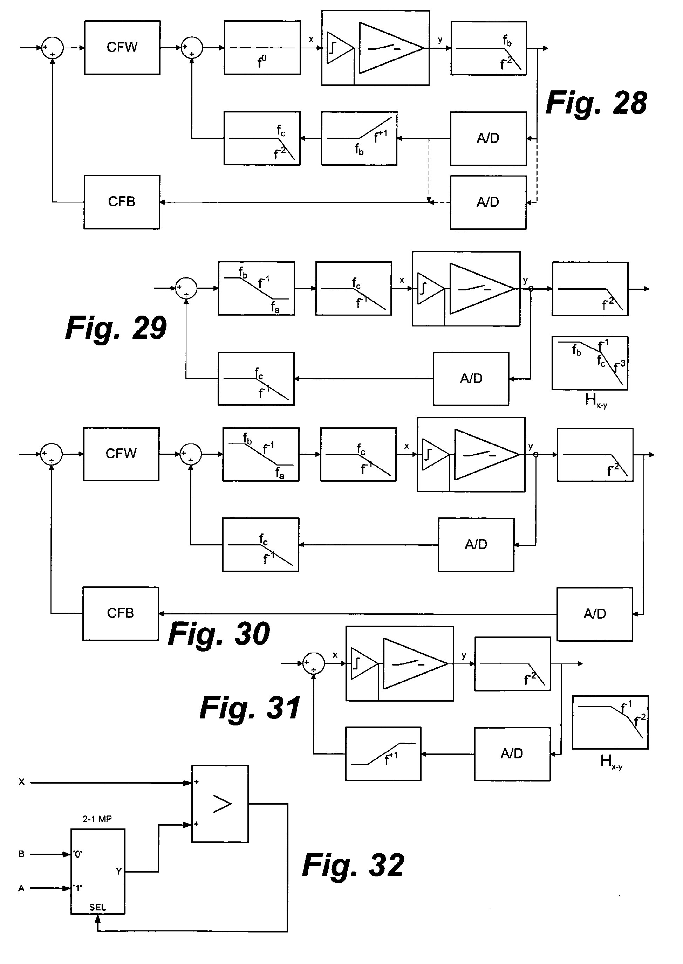

Figs. 25-31 show different embodiments of phase shift types of modulators, which use a digital power stage without hysteresis, i.e. the hysteresis window is equal to zero. Fig. 25 shows a DISOM version of the COM implementation (see also WO 98/19391). The A/D-converter can be neglected since the output from the switching stage or the switching amplifier is digital. However, an A/D-converter can be used to compensate for errors of the power stage. Fig. 26 shows a similar COM-type power modulator with an output filter and an outer control loop. The outer loop must include an A/D-converter. Fig. 27 shows a DISOM version of a GCOM (see also WO 2004/047286). The A/D-converter must be of a fast type. Fig. 28 shows a similar GCOM-type power modulator with an outer control loop. A single A/D-converter can be used for both the inner feedback loop and the outer control loop. Fig. 29 shows a DISOM version of a CCOM (see also WO 02/25357). The embodiment uses a current measurement at the output of the switching stage or the switching amplifier, and the feedback loop must include a fast A/D-converter. Fig. 30 shows a similar CCOM-type modulator with an outer control loop, which must include a separate A/D-converter. Fig. 31 shows yet another embodiment of the phase-shift type modulator.

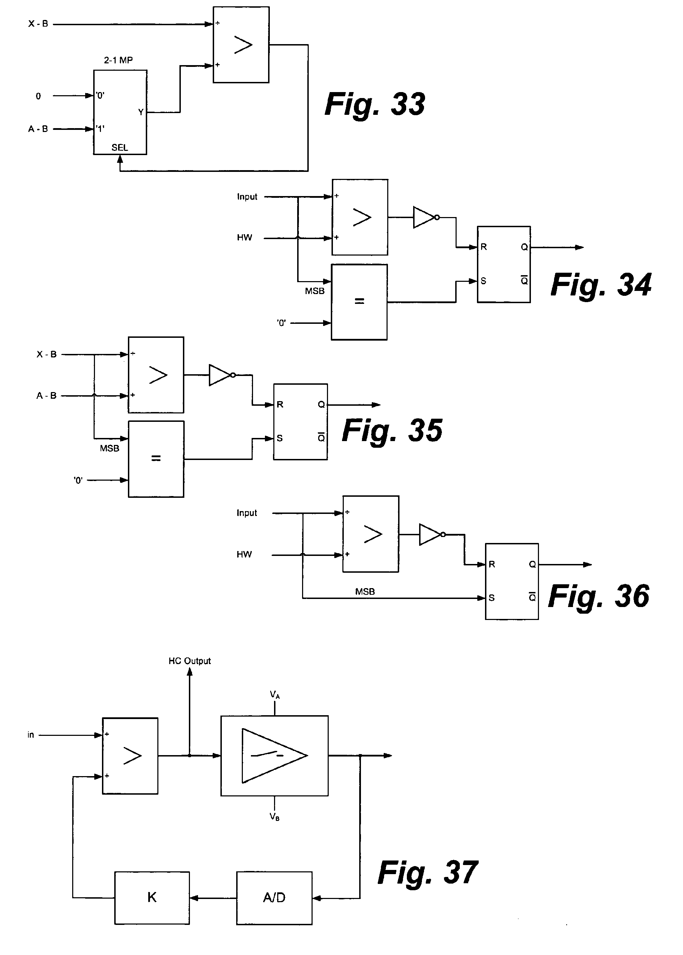

Figs. 32-42 show different embodiments of hysteresis comparators for use in DISOMs. In the figures X, "in", and "input" denote the signal from for instance the summing junction or from a filter of the forward block, $V_a$ and $V_b$ are the signals from the positive and negative sides of the hysteresis windows, respectively, $V_b$ usually being a negative number. The embodiment shown in Fig. 32 incorporates a 2-1 multiplexer and a digital comparator, both of which are well known to a person skilled in the art. A and B denote the input from the positive and negative side of the hysteresis window, respectively, where $A = K*V_a$ and $B = K*V_b$, where K is an arbitrary constant. The digital comparator compares the input X and the output Y from the 2-1 multiplexer. The output of the digital comparator is fed back to the SEL terminal of the 2-1 multiplexer. A and B are input to the 2-1 multiplexer, and the output of the 2-1 multiplexer is either A or B depending on the state of SEL. Fig. 33 shows a similar embodiment, but where the reference point of the input is shifted (with the value B).

Fig. 34 shows yet another embodiment, which incorporates two digital comparators, and an S-R latch, the functions of which all are well known to a person skilled in the art.

Fig. 35 is substantially the same embodiment as shown in Fig. 34. The hysteresis window HW input to the digital comparator is the difference between A and B. Fig. 36 shows a simplified embodiment with only one comparator.

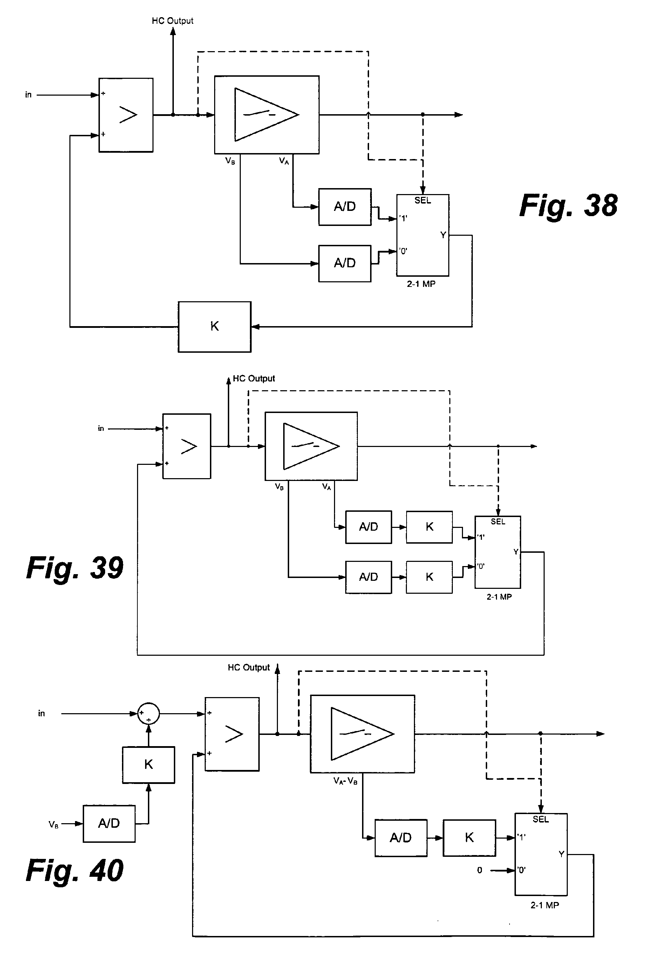

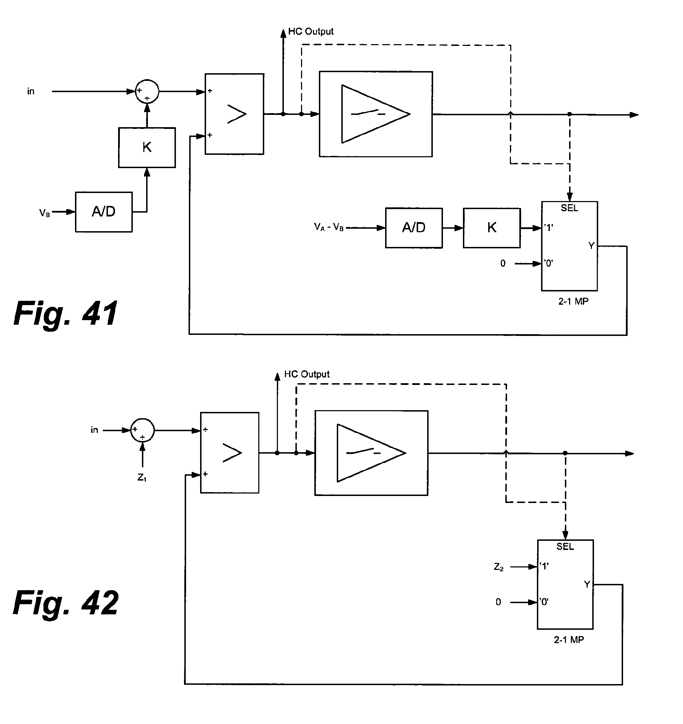

Fig. 37 shows a digital power hysteresis comparator including a digital comparator with a hysteresis comparator output (HC Output), which is input to a power stage, the output of which is fed to a feedback loop comprising an A/D-converter and a constant gain K. This embodiment compensates for the voltage drop in the transistors of the power stage. Fig. 38 shows an alternative embodiment of a digital power hysteresis comparator, which includes a 2-1 multiplexer in the feedback loop. As long as the output from the power stage is fed to the SEL terminal of the 2-1 multiplexer, this embodiment functions identical to the embodiment shown in Fig. 37, where both timing errors and voltage supply errors of the power stage are compensated. If the output from the hysteresis comparator (HC Output) is fed to SEL, no compensations are carried out. Figs. 39-41 show similar embodiments. The hysteresis window in Fig. 41 is constant. Fig. 42 shows yet another implementation, where $Z_1$ is a constant and $Z_2$ is the hysteresis window, which can be constant or externally controlled.

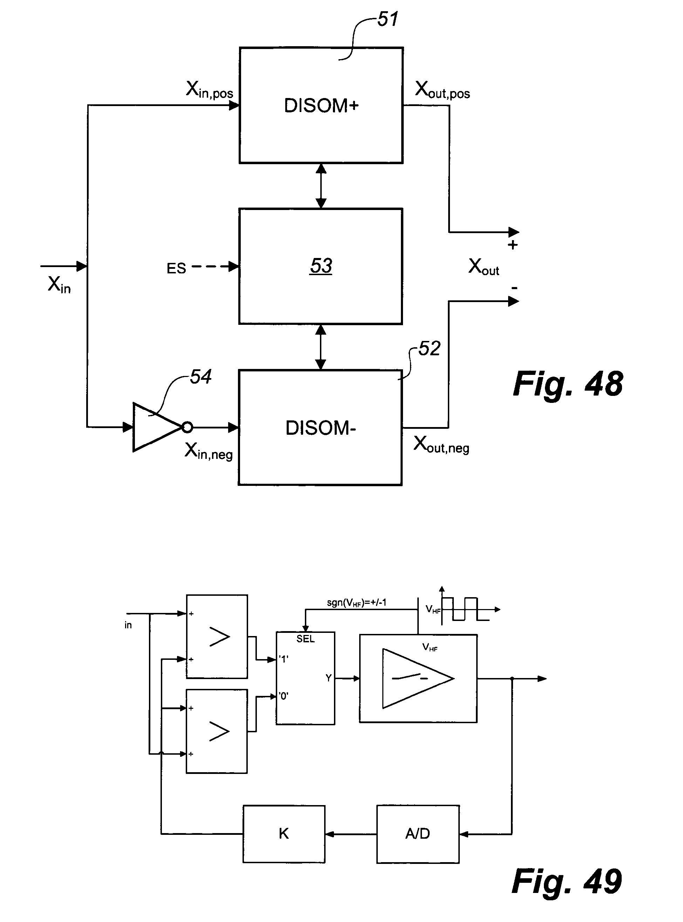

Fig. 49 shows a digital implementation of a SICAM modulator (see also US provisional application 60/714,077). The input (in) is fed to two identical digital comparators, which compare the input with the signal fed back through the feedback loop. The outputs from the two digital comparators are digitally inverted. The outputs are fed to a 2-1 multiplexer, the output of which is determined by the state of SEL. The output from the 2-1 multiplexer is fed to the alternating output stage, which preferably comprises a switching amplifier with bidirectional switches. The alternating output stage is supplied with an AC-voltage from an HF-link converter, the AC-voltage also being fed to the SEL. The polarity of the HF-link converter thereby determines the output from the 2-1 multiplexer. The digital output from the alternating output stage is fed back through the feedback loop comprising an A/D-converter and a feedback block with gain K. The transfer functions of the feedback block and forward block can of course be any desired function. The SICAM modulator can also contain an output filter and/or one or more additional feedback loops.

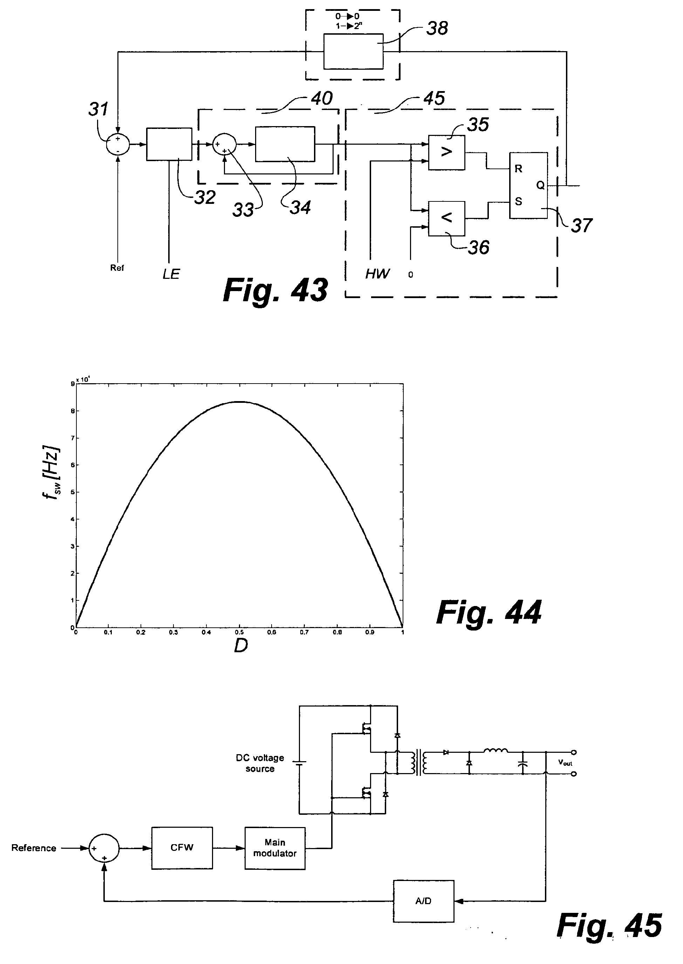

An offline DC/DC converter has been constructed in order to carry out a proof-of-concept of the DISOM concept. A block diagram of the main modulator is shown in Fig. 43. The shown embodiment is one of the simplest forms of a DISOM modulator. The main modulator is digital and has been implemented in a Complex Programmable Logic Device (CPLD). An input REF from an external controller is fed to a summing junction 31, which is also fed by the signal from the feedback loop. The summing junction 31 extracts the difference between these two signals. The output from the summing junction 31 is sent to a latch 32, which also receives a latch enable signal LE. The output from the latch 32 is sent to an integrator 40, which consists of an adder 33 and a clocked latch 34, the output of the clocked latch 34 being fed back to the adder 33. The output of the integrator 40 is sent to a comparator 45 with hysteresis. The comparator 45 comprises two separate comparators 35, 36 and an S-R latch 37. The output from the integrator is fed to both comparators 35, 36, one comparator 35 comparing the signal to the signal from the hysteresis window HW and the other comparator 36 comparing the signal to zero. The output from the two comparators 35, 36 are fed to the R and S terminals of the S-R latch 37, respectively. The output from the S-R latch 37 is fed back to a multiplexer 38, which sets the output to zero if the input is zero and the output to $2^n$ if the input is one. The output of the multiplexer 38 is fed back to the summing junction 31.

The switching frequency $f_{SW}$ of the main modulator is given as a function of the duty cycle of the modulator output given by the following expression:

$$f_{sw} = \frac{2^n}{T_{clock} \cdot HW} \cdot D \cdot (1 - D),$$

where $f_{sw}$ is the switching frequency, $n$ is number of bits of the reference input REF, $T_{clock}$ is the period of time for the clocked latch, $HW$ is the hysteresis window, and $D$ is the duty cycle. A plot of the switching frequency $f_{sw}$ versus the duty cycle $D$ is shown in Fig. 44 for $n = 8$, $T_{clock} = 50$ ns and HW = 15360.

The overall control loop including the DC/DC converter is shown in Fig. 45. The CFB block 22 is not included in the feedback loop, since the CFB block simply has a gain of one in the shown embodiment. The CFW block has a transfer function with three zeros and an integrator. The placement of the three zeros determines the overall transfer function of the DC/DC converter.

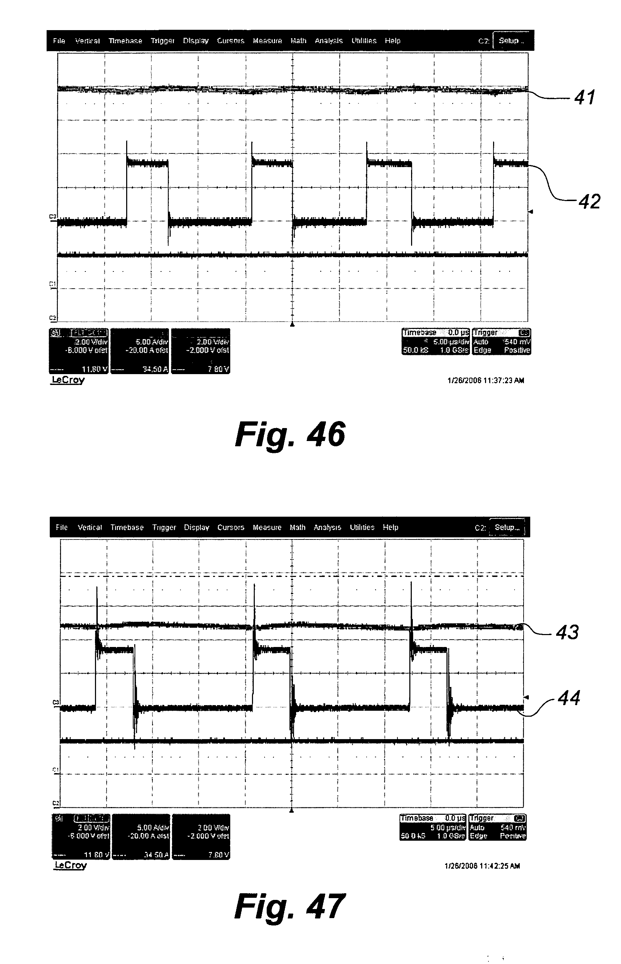

Some experimental results measured on the prototype are shown in fig. 46 and 47. The output voltage is 12V and the load current is 10A in Fig. 46. The lower trace 42 shows the gate signal for the two MOSFETs in the offline converter and the upper trace 41 shows the output voltage. The switching frequency is approximately 80 kHz. The output voltage is 9V and the load current is 10A in Fig. 47. The duty cycle of the MOSFET gate signal has been decreased and the switching frequency has fallen to 59 KHz. The lower trace 77 shows the gate signal for the two MOSFETs in the offline converter and the upper trace 76 shows the output voltage. The measurements shown in Fig. 46 and 47 correspond well with the theoretical curve shown in Fig. 44, which shows that the switching frequency is decreased by a decrease in duty cycle.

Fig. 48 shows a block diagram of a DISOM version for synchronising two modulators. The DISOM+ 51 and DISOM- 52 can be any type of DISOM modulator, for instance of the phase shift type or the hysteresis type. The reference signal $X_{in}$ is fed to DISOM+ 51 and a digital inverter 54, which inverts the reference signal and feeds it to DISOM-52. The two modulators 51, 52 are synchronised by the synchronisation block 53. There are several ways to implement the synchronisation, for instance by an optional external synchronisation signal ES, via the capacitors of the output filter, by summing part of the high frequency part of the carrier waves, by summing parts of the hysteresis window, or by master/slave control.

The above description of the invention reveals that it is obvious that it can be varied in many ways. Such variations are not to be considered a deviation from the scope of the invention, and all modifications, which are obvious to persons skilled in the art, are also to be considered comprised by the scope of the succeeding claims.

## Claims

1. A digital self-oscillating modulator (1) comprising a forward loop and a feedback loop, wherein the feedback loop comprises a feedback block (18) having a transfer function (MFB) and a digital output, and the forward loop comprises an alternating output stage (14), an optional output filter (15), and a forward block (12) having a transfer function (MFW) and a digital output, said digital output from the forward block (12) being input to the alternating stage (14), said forward block being provided with means for calculating the difference between the digital output from the feedback block and a digital reference signal, and wherein an output voltage of the modulator either from the alternating output stage (14) and/or the output filter (15) is fed back through the feedback block.

2. A digital self-oscillating modulator (1) according to claim 1, **characterised in that** the forward block (12) includes a comparator block.

3. A digital self-oscillating modulator according to claim 1 or 2, **characterised in that** the forward block (12) includes a comparator (13) with hysteresis or a comparator block and a hysteresis block.

4. A digital self-oscillating modulator according to claim 2 and 3, **characterised in that** the comparator block includes a multiplexer and a digital comparator, said multiplexer being adapted to multiplex signals from the positive and negative sides of the hysteresis block, the output from the multiplexer being sent to the digital comparator, which compares the output from the multiplexer with a digital reference signal.

5. A digital self-oscillating modulator according to one of claims 2-4 **characterised in that** the comparator block includes a digital comparator and a S-R latch.

6. A digital self-oscillating modulator according to any of the preceding claims, **characterised in that** the feedback loop additionally comprises an A/D-converter (17).

7. A digital self-oscillating modulator (1) according to any of the preceding claims, **characterised in that** the forward block (12) includes an integrator.

8. A digital self-oscillating modulator (1) according to claim 7, **characterised in that** the integrator comprises an adder and a clocked latch.

9. A digital self-oscillating modulator (1) according to any of the preceding claims, **characterised in that** the transfer function (MFW) of the forward block (12), the transfer function (MFB) of the feedback block (18), as well as the transfer function of the optional output filter (15) depend on the desired open-loop transfer function.

10. A digital self-oscillating modulator (1) according to any of the preceding claims, **characterised in that** the alternating output stage (14) is a switching amplifier with bidirectional switches.

11. A digital self-oscillating modulator (1) according to any of the preceding claims, **characterised in that** the means for comparing the signal fed back with the reference signal comprises two identical digital comparator sections, which have inverted inputs.

12. A digital self-oscillating modulator (1) according to any of the preceding claims, **characterised in that** a digital multiplication element is placed together with the forward block before the alternating output stage.

13. A digital self-oscillating modulator (1) according to claims 11 and 12, **characterised in that** the alternating output stage (14) is supplied with an AC-voltage from an AC-link converter and that the digital multiplication element works by switching between the two identical digital comparator sections with inverted inputs, said switching being controlled by the sign of the AC-voltage from the AC-link converter.

**14.** A digital self-oscillating modulator (1) according to any of the preceding claims, **characterised in that** one or more of the zero points or poles of the feedback block (18) and of the forward block (12) are coinciding or approximately coinciding with the pole or zero points of the optional output filter (15).

**15.** A digital self-oscillating modulator (1) according to any of the preceding claims, **characterised by** further including one or more additional output filters, one or more additional feedbacks (22) with transfer functions (CFB) coupled either after the output stage, after the output filter or after one or more of the additional output filters, as well as one or more forward blocks (20), which include both means for calculating the difference between one of the signals fed back from the additional function blocks and a reference signal, as well as a transfer function (CFW).

**16.** A digital self-oscillating modulator (1) according to claim 12, **characterised by** the transfer function (MFB) of the feedback block (18), the transfer function (MFW) of the forward block (12), the additional output filters, the transfer functions (CFB) of the additional feedback blocks (22) and the transfer function (CFW) of the additional forward blocks (20) together generating the desired total transfer function.

**17.** A digital self-oscillating modulator according to one of the preceding claims, **characterised by** the desired total transfer function being similar to a first order low-pass-characteristic or integrator characteristic.

**18.** A synchronised modulator comprising two digital modulators (51, 52) according to any of the preceding claims, **characterised in that** a reference voltage ($X_{in,pos}$) is input to a first digital modulator (51) and a digital inverted reference voltage ($X_{in,neg}$) is input to a second digital modulator (52), the outputs from said first and said second digital modulator being synchronised by use of a synchronisation block.

*Fig. 1*

*Fig. 2*

*Fig. 3*

*Fig. 4*

*Fig. 5*

*Fig. 6*

*Fig. 7*

*Fig. 8*

*Fig. 9*

*Fig. 10*

*Fig. 11*

*Fig. 12*

Fig. 13

Fig. 14

Fig. 15

Fig. 16

Fig. 17

**Fig. 18**

**Fig. 19**

**Fig. 20**

**Fig. 21**

**Fig. 22**

**Fig. 23**

**Fig. 24**

**Fig. 25**

**Fig. 26**

**Fig. 27**

*Fig. 28*

*Fig. 29*

*Fig. 30*

*Fig. 31*

*Fig. 32*

*Fig. 33*

*Fig. 34*

*Fig. 35*

*Fig. 36*

*Fig. 37*

Fig. 38

Fig. 39

Fig. 40

HC Output

in

$V_B$

A/D

K

$V_A - V_B$

A/D

K

SEL

'1'

'0'

0

Y

2-1 MP

*Fig. 41*

HC Output

in

$Z_1$

SEL

$Z_2$

'1'

'0'

0

Y

2-1 MP

*Fig. 42*

**Fig. 43**

**Fig. 44**

**Fig. 45**

**Fig. 46**

**Fig. 47**

51

$X_{in,pos}$ → DISOM+ → $X_{out,pos}$

+

$X_{in}$ → ES ---→ 53 → $X_{out}$

-

54

$X_{in,neg}$ → DISOM- → $X_{out,neg}$

52

**Fig. 48**

sgn($V_{HF}$)=+/-1    $V_{HF}$

in → > → '1'

SEL → Y → $V_{HF}$

> → '0'

K ← A/D

**Fig. 49**

**European Patent Office**

**EUROPEAN SEARCH REPORT**

Application Number

EP 06 38 8014

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | WO 2004/100356 A (DANMARKS TEKNISKE UNIVERSITET; POULSEN, SOEREN) 18 November 2004 (2004-11-18) * page 11, line 22 - page 15, line 18 * ----- | 1-3,7,9, 10,14-18 | INV. H03F3/217 H03F1/32 |
| D,A | WO 02/25357 A (BANG & OLUFSEN POWERHOUSE A/S; NIELSEN, KARSTEN) 28 March 2002 (2002-03-28) * the whole document * ----- | | |
| D,A | DE 198 38 765 A1 (ELBO GMBH) 11 May 2000 (2000-05-11) * the whole document * ----- | | |
| D,A | WO 98/19391 A (BANG & OLUFSEN A/S; KARSTEN, NIELSEN) 7 May 1998 (1998-05-07) * the whole document * ----- | | |

TECHNICAL FIELDS SEARCHED (IPC)

H03F

The present search report has been drawn up for all claims

| Place of search | Date of completion of the search | Examiner |
|---|---|---|
| Munich | 6 July 2006 | Kahn, K-D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 38 8014

This annex lists the patent family members relating to the patent documents cited in  the above-mentioned European search report.
The members are as contained in the European Patent Office EDP file on
The European Patent Office is in no way  liable for these particulars which are merely  given for the purpose of information.

06-07-2006

| Patent document cited in search report | | Publication date | Patent family member(s) | | Publication date |
|---|---|---|---|---|---|
| WO 2004100356 | A | 18-11-2004 | EP | 1632024 A2 | 08-03-2006 |
| WO 0225357 | A | 28-03-2002 | AU | 1631802 A | 02-04-2002 |
| | | | CN | 1471758 A | 28-01-2004 |
| | | | EP | 1323231 A2 | 02-07-2003 |
| | | | JP | 2004510397 T | 02-04-2004 |
| DE 19838765 | A1 | 11-05-2000 | NONE | | |
| WO 9819391 | A | 07-05-1998 | AT | 315285 T | 15-02-2006 |
| | | | AT | 255784 T | 15-12-2003 |
| | | | AU | 734813 B2 | 21-06-2001 |
| | | | AU | 4772897 A | 22-05-1998 |
| | | | CA | 2271041 A1 | 07-05-1998 |
| | | | CN | 1235711 A | 17-11-1999 |
| | | | DE | 69726592 D1 | 15-01-2004 |
| | | | DE | 69726592 T2 | 11-11-2004 |
| | | | DK | 0935846 T3 | 22-03-2004 |
| | | | EP | 0935846 A2 | 18-08-1999 |
| | | | ES | 2212082 T3 | 16-07-2004 |
| | | | JP | 3346579 B2 | 18-11-2002 |
| | | | JP | 2001503575 T | 13-03-2001 |
| | | | KR | 2000052932 A | 25-08-2000 |
| | | | PT | 935846 T | 30-04-2004 |
| | | | US | 6297692 B1 | 02-10-2001 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 19838765
- WO 0225357 A
- WO 9819391 A
- WO 04100356 A
- US 60714077 B
- WO 2004047286 A